# FASCICULE DE BREVET EUROPEEN

(11) **EP 0 876 744 B1**
(45) Date de publication et mention de la délivrance du brevet: **19.01.2000**
(21) Numéro de dépôt: 96938294.4
(22) Date de dépôt: 12.11.1996
(51) Int. Cl.: H05K 7/20, H05K 7/14

(54) **CONNECTEUR THERMIQUE POUR CARTE OU BOITIER D'ELECTRONIQUE**
THERMISCHE VERBINDUNG FÜR EINE LEITERPLATTE ODER EIN ELEKTRONISCHES GEHÄUSE
THERMAL CONNECTOR FOR AN ELECTRONIC CARD OR HOUSING

(30) Priorité: 14.11.1995 FR 9513468
(43) Date de publication de la demande: 11.11.1998
(73) Titulaire: THOMSON-CSF, 75008 Paris (FR)
(72) Inventeur: BARRIERE, Jean-Michel, F-94117 Arcueil Cédex (FR)
(74) Mandataire: Beylot, Jacques
(86) Numéro de dépôt international: FR9601779
(87) Numéro de publication internationale: WO9718696

(56) Documents cités:
- FR-A- 2 514 601
- US-A- 3 975 805
- US-A- 4 979 073
- NAVY TECHNICAL DISCLOSURE BULLETIN, vol. 3, no. 12, Décembre 1978, pages 1-3, XP002010201 HOLT, AHLSTRAND, LEE: "Holder for printed wiring board"

## Description

La présente invention est relative aux échanges thermiques entre une plaque et un élément produisant ou absorbant de la chaleur, par exemple entre une plaque de paroi froide et le rebord extérieur en forme de plaque d'un drain thermique équipant une carte électronique ou un boîtier de cartes électroniques pour permettre le transfert vers la paroi froide des calories engendrées par les composants électroniques de la carte ou du boîtier et collectées par le drain thermique.

Le problème de l'évacuation des calories se pose notamment, dans les appareils ou équipements électriques comportant des cartes électroniques équipées de composants électroniques dissipant une quantité de chaleur importante et devant malgré tout être maintenus à une faible température pour éviter leur dégradation.

Pour évacuer les calories, il est connu d'équiper une carte de circuits électroniques ou un boîtier de cartes de circuits électroniques, d'un drain thermique se prolongeant à l'extérieur de la carte ou du boîtier par un rebord en forme de plaque destiné à être attaché à une paroi réfrigérée.

La fixation entre la plaque de rebord d'un drain thermique et la paroi froide doit à la fois présenter une faible résistance thermique et être démontable pour permettre un éventuel retrait de la carte électronique ou du boîtier de cartes électroniques. C'est pourquoi, elle est habituellement réalisée au moyen d'un connecteur débrochable à deux positions, l'une verrouillée, l'autre non.

US-A-4 979 073 révèle un connecteur thermique pour fixer une carte de circuit imprimé.

Une autre manière connue de réaliser un raccordement thermique entre une plaque de rebord d'un drain thermique et une paroi froide consiste à pincer la plaque de rebord du drain thermique dans une rainure de la paroi froide au moyen d'une cale ou connecteur expansible. Un tel système d'interconnexion thermique est connu notamment par la demande de brevet français n° 2 514 601. La cale ou connecteur expansible qui vient pincer la plaque de rebord d'un drain thermique dans une rainure à section rectangulaire présente la forme d'une réglette. Cette réglette s'encastre dans la rainure au côté de la plaque de rebord du drain thermique. Elle se compose d'un corps allongé creux de section rectangulaire adaptée à celle de la rainure. Ce corps renferme, sur tout son long, un logement à ouverture latérale dans lequel sont fixés une lamelle de ressort dépassant latéralement du côté de la plaque de rebord du drain thermique, et un axe rotatif de commande à section cylindrique à méplat constituant une came allongée prenant appui sur la lamelle de ressort. L'axe rotatif de commande permet, en fonction de la position de son méplat par rapport à la lamelle de ressort, de faire saillir plus ou moins la lamelle de ressort latéralement en dehors du corps de connecteur en direction de la plaque de rebord d'un drain thermique. Il est pourvu à une de ses extrémités qui dépasse du corps, d'une empreinte permettant de le manoeuvrer à l'aide d'une clef.

Un tel connecteur thermique présente l'inconvénient d'être relativement complexe et coûteux à fabriquer et également d'être encombrant puisque son corps doit, soit trouver place entièrement dans une rainure de plaque froide ce qui impose une épaisseur minimale à la plaque froide, soit dépasser en partie à l'extérieur d'une rainure de la plaque froide ce qui réduit d'autant l'espace disponible pour les cartes et boîtiers d'électronique.

La présente invention a pour but de lutter contre les inconvénients précités.

Elle a pour objet un connecteur thermique pour fixer une carte ou boîtier d'électronique équipé d'un drain thermique se prolongeant à l'extérieur de la carte ou du boîtier par un rebord en forme de plaque, à une paroi froide en pinçant ledit rebord extérieur en forme de plaque du drain thermique contre un bord d'une rainure pratiquée dans la paroi froide. Ce connecteur thermique est remarquable en ce qu'il comporte une lamelle de ressort de forme allongée en gouttière, avec deux ailes réunies par une embase et une section droite ayant la forme générale d'un U, pourvue, d'un côté de la base du U en regard du rebord extérieur en forme de plaque du drain thermique, de pattes latérales d'écartement et un axe rotatif de commande à section droite ronde avec un méplat, qui est disposé dans la gouttière de la lamelle de ressort et qui, en prenant appui entre les deux ailes de la lamelle de ressort, permet d'en modifier l'écartement en fonction de son orientation, et en ce qu'il est prévu pour être monté dans une rainure de la paroi froide à section en demi-queue d'aronde, avec deux bords tendant à se resserrer en direction de son ouverture pour emprisonner la lamelle de ressort.

Avantageusement, l'axe rotatif de commande est emprisonné entre les ailes de la lamelle de ressort grâce à des pattes découpées dans la lamelle de ressort et recourbées autour de lui au niveau d'une ou plusieurs gorges échelonnées sur sa longueur.

Avantageusement, l'axe rotatif de commande présente une extrémité ou tige de manoeuvre, qui dépasse de la lamelle de ressort et qui est pourvue d'une empreinte permettant de la manoeuvrer avec une clef.

Avantageusement, des moyens mécaniques assurent le blocage en translation de la lamelle de ressort dans une rainure de la paroi froide pour éviter son déplacement lors d'une mise en place ou d'un retrait par coulissement d'un rebord de drain thermique dans sa rainure. Ces moyens mécaniques de blocage en translation peuvent être formés d'une part, d'une patte d'extrémité équipant la base de la lamelle de ressort à l'extrémité opposée à la tige de manoeuvre de l'axe rotatif de commande et d'une vis fixant cette patte d'extrémité dans le fond de la rainure de la paroi froide, et d'autre part, à l'aide de deux pattes latérales prolongeant la base de la lamelle de ressort à son extrémité tournée vers la tige de manoeuvre de l'axe rotatif de commande et prenant appui dans des logements creusés sur le côté de la paroi froide au débouché de la rainure. Ils peuvent être aussi constitués d'une patte latérale découpée dans une aile de la lamelle de ressort s'encliquetant dans un logement creusé dans bord de la rainure.

Avantageusement, la paroi froide est pourvue latéralement, du côté où émerge la tige de manoeuvre de l'axe rotatif de commande, d'un bossage qui coopère avec une came taillée à l'extrémité de la clef de manoeuvre de l'axe rotatif de commande pour limiter la possibilité de rotation de l'axe rotatif de commande à un quart de tour.

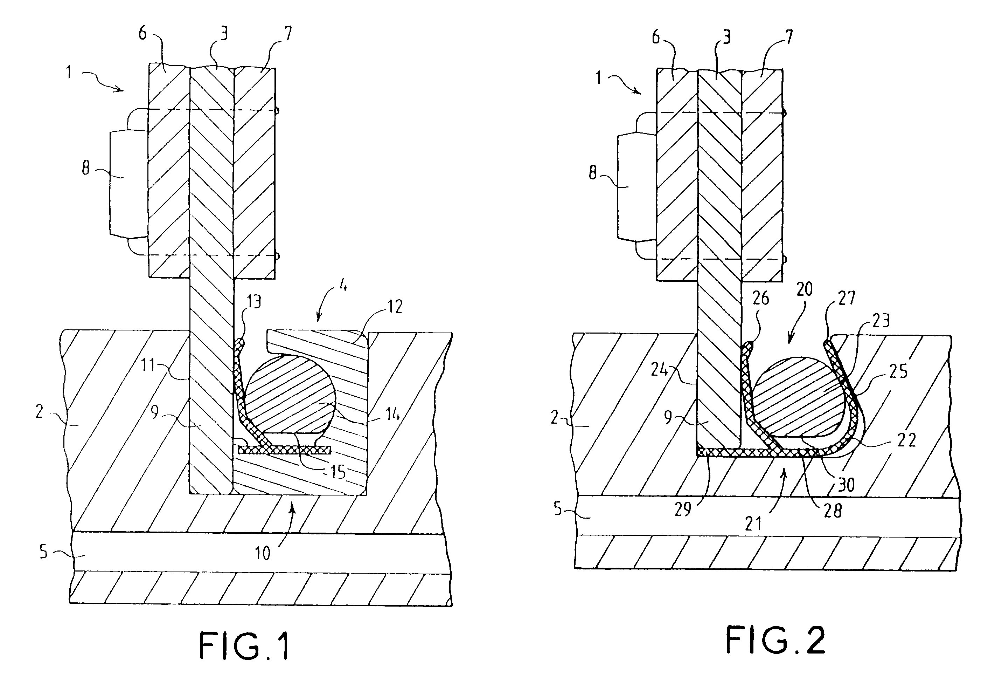

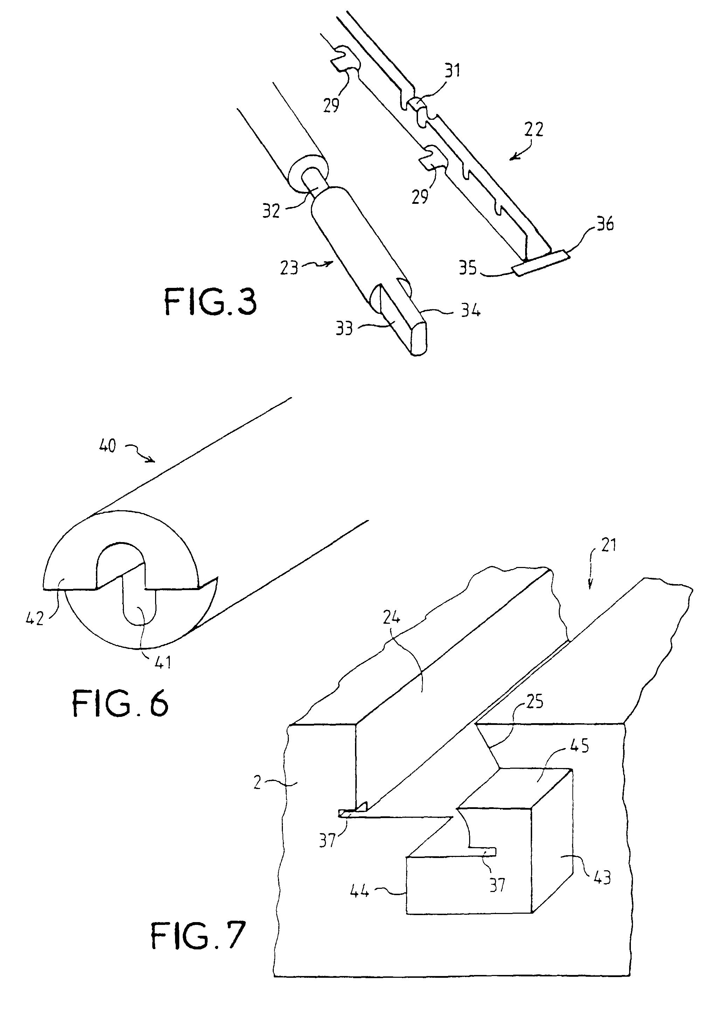

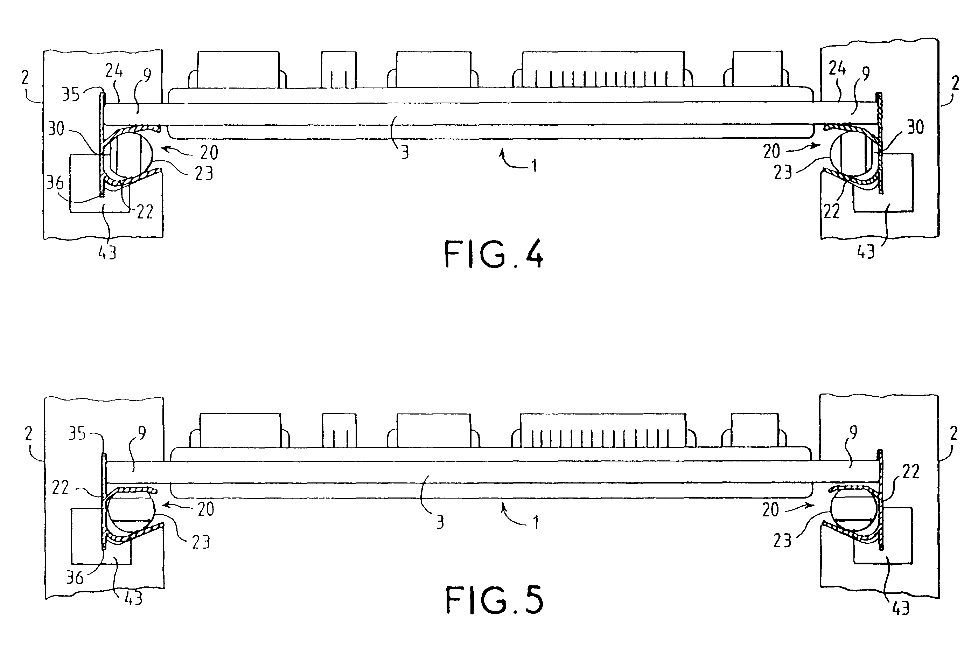

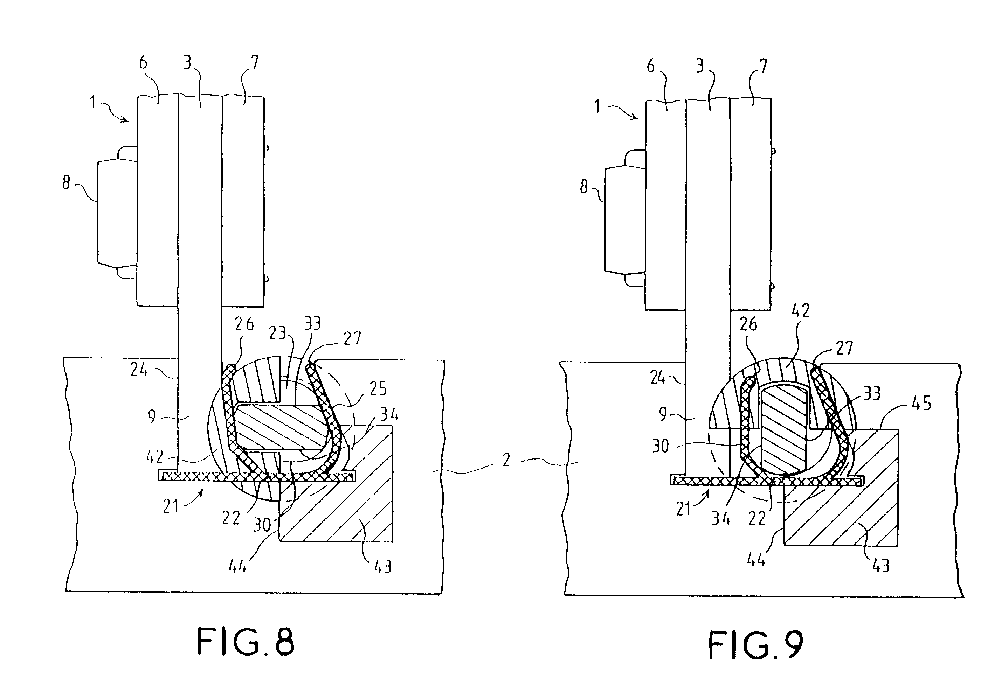

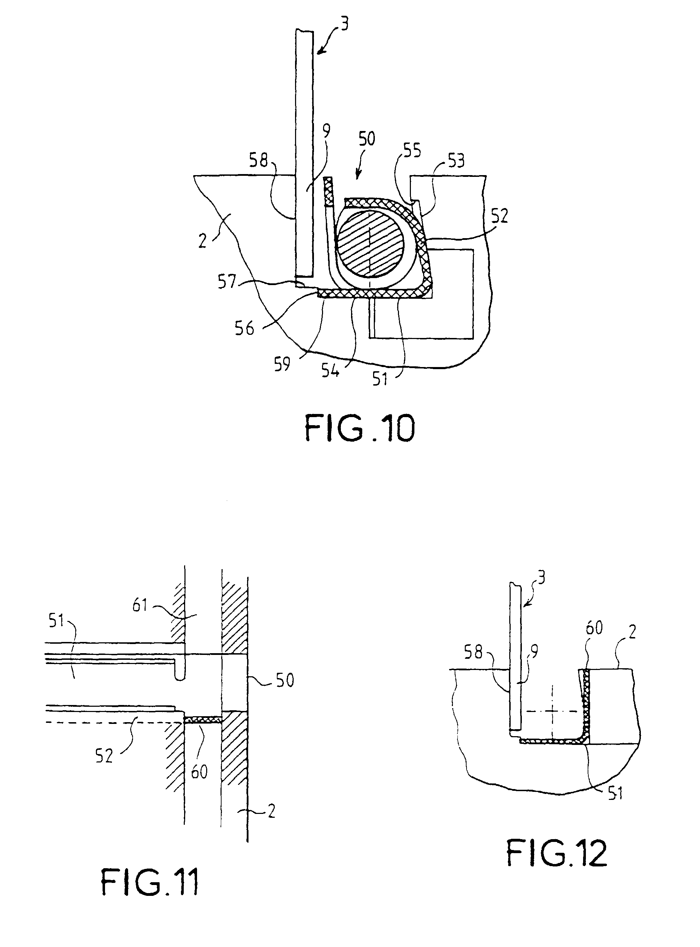

D'autres caractéristiques et avantages de l'invention ressortiront de la description ci-après d'un mode de réalisation donné à titre d'exemple. Cette description sera faite en regard du dessin dans lequel :
- une figure 1 représente, en coupe de section droite, un connecteur thermique selon l'art antérieur ;
- une figure 2 représente, en coupe de section droite, un connecteur thermique selon l'invention ;
- une figure 3 représente, en perspective partielle et démontées une des extrémités de la lamelle de ressort et de l'axe rotatif de commande d'un connecteur thermique selon l'invention ;
- des figures 4 et 5 représentent, vue de profil, une carte de circuits électroniques montée entre des parois froides au moyen de connecteurs thermiques selon l'invention en positions verrouillée et déverrouillée ;
- une figure 6 représente une vue en perspective de l'extrémité d'une clef adaptée à la manoeuvre de l'axe rotatif de commande d'un connecteur thermique selon l'invention montrant l'empreinte de la clef et son doigt d'extrémité prévu pour coopérer avec un bossage de la paroi froide pour limiter le débattement en rotation de la clef ;
- une figure 7 montre un bossage qui équipe latéralement la paroi froide au débouché d'une rainure servant de logement à un connecteur thermique selon l'invention, du côté donnant accès à la tige de manoeuvre de l'axe rotatif de commande du connecteur thermique et qui permet , en coopération avec le doigt d'extrémité de la clef de limiter le débattement en rotation de cette dernière ;
- des figures 8 et 9 montrent, en coupe de section droite, un connecteur thermique selon l'invention avec sa clef de manoeuvre, en positions verrouillée et déverrouillée ;
- une figure 10 montre en coupe de section droite, une variante du connecteur thermique selon l'invention avec un profil particulier de la rainure de logement de la lamelle de ressort permettant un maintien en légère contrainte de cette dernière ; et
- des figures 11 et 12 montrent, vue en élévation et en coupe, une patte latérale de la lamelle de ressort d'un connecteur thermique selon l'invention assurant le blocage en translation de ladite lamelle de ressort dans sa rainure.

Par soucis de clarté, les mêmes éléments portent d'une figure à l'autre les mêmes références.

On distingue sur la figure 1, le bord d'une carte de circuits électroniques 1 fixée à une paroi froide 2 par sa plaque de drain thermique 3 au moyen d'un connecteur thermique classique 4.

La paroi froide 2 est parcourue par des canaux 5 où circule un fluide réfrigérant.

Le drain thermique 3 de la carte de circuits électroniques 1 est, par exemple une plaque de cuivre intercalée entre deux plaques de circuits imprimés multicouches 6, 7 supportant des composants électroniques 8 dissipant de la chaleur. Il recueille les calories engendrées par les composants de la carte afin de les évacuer à l'extérieur dans la paroi froide 2. Pour ce faire, il présente un rebord 9 en forme de plaque, qui dépasse à l'extérieur de la carte de circuits électroniques 1 et qui est attaché à la paroi froide 2.

La fixation du rebord 9 en forme de plaque du drain thermique 3 à la paroi froide 2 doit être démontable pour permettre un retrait de la carte de circuits électroniques 1. Elle se fait habituellement, comme représenté dans cette figure 1, par pinçage du rebord 9 dans une rainure 10 à section rectangulaire de la paroi froide 2, au moyen d'une cale ou connecteur expansible 4 qui s'encastre dans la rainure 10 au côté du rebord 9 du drain thermique 3 de manière à le repousser contre l'un 11 des bords de la rainure 10 pour le mettre en contact thermique étroit avec la paroi froide 2.

Le connecteur expansible 4 se présente sous la forme d'une réglette avec un corps allongé creux 12 de section rectangulaire adaptée à celle de la rainure 10 de la paroi froide 2. Ce corps 12 renferme, sur tout son long, un logement à ouverture latérale dans lequel sont fixés une lamelle de ressort 13 dépassant latéralement du côté de la plaque de rebord 9 du drain thermique 3, et un axe rotatif de commande 14 à section droite cylindrique à méplat 15 constituant une came allongée prenant appui sur la lamelle de ressort 13. L'axe rotatif de commande 14 permet, en fonction de la position de son méplat 15 par rapport à la lamelle de ressort 13, de faire saillir plus ou moins la lamelle de ressort 13 latéralement en dehors du corps 12 de connecteur en direction de la plaque de rebord 9 d'un drain thermique 3. Il est pourvu à une de ses extrémités qui dépasse du corps, d'une empreinte permettant de le manoeuvrer à l'aide d'une clef.

Un tel connecteur thermique 4 présente l'inconvénient d'être relativement encombrant en épaisseur, en raison de son corps allongé creux 12 servant de socle à la lamelle de ressort 13 qui doit nécessairement avoir une certaine épaisseur à la base. S'il doit trouver sa place entièrement dans une rainure 10, il impose une épaisseur minimale à la paroi froide 2. Si, au contraire, il dépasse en partie de la rainure 10, il réduit l'espace disponible pour les composants de la carte 1.

En outre la fabrication d'un tel connecteur thermique est relativement coûteuse car elle réclame la réalisation de son corps par profilage, selon une forme complexe, et un assemblage de trois pièces.

Le connecteur thermique 20 de la figure 2 ne présente pas ces inconvénients. Comme on peut le voir, il se loge dans une rainure 21 de la paroi froide 2 à section droite en demi-queue d'aronde et ne comporte qu'une lamelle de ressort 22 et un axe rotatif de commande 23.

La rainure 21 de la paroi froide 2 présente un bord 24 perpendiculaire à la surface de la paroi froide 2 contre lequel vient s'appuyer la plaque de rebord 9 du drain thermique 3 de la carte de circuits électroniques 1, et un bord 25 penché, en surplomb, resserrant son ouverture.

La lamelle de ressort 22 a une forme allongée en gouttière, avec deux ailes 26, 27 réunies par une embase 28. Elle a une section droite en forme générale d'un U adaptée au profil de la rainure 21 de la plaque froide 2 dans laquelle elle s'encastre en présentant la base de sa gouttière en vis à vis du fond de la rainure. Une de ses ailes 27, celle qui vient au contact du bord penché 25 de la rainure 21 de la plaque froide 2, est inclinée vers l'autre aile 26 pour s'adapter à l'inclinaison en surplomb de ce bord. L'écartement entre ses ailes 26, 27 est légèrement inférieur à la largeur de la rainure 21 de la plaque froide 2 pour ménager sur le côté un espace pour l'introduction dans la rainure 21 de la plaque de rebord 9 du drain thermique 3. Un jeu latéral de la lamelle de ressort 22 au fond de la rainure 21 de la paroi froide 2 est évité grâce à des pattes latérales d'écartement 29 qui sont découpées dans la base de l'aile 26 de la lamelle de ressort 22 tournée vers la plaque de rebord 9 du drain thermique 3. Ces pattes latérales d'écartement 29 suivent le fond de la rainure 21 de la plaque froide 2 et viennent en butée contre son bord perpendiculaire 24.

Grâce au profil en demi-queue d'aronde de la rainure 21 de la paroi froide 2, au profil adapté de la lamelle de ressort 22 et à ses pattes latérales d'écartement 29, la lamelle de ressort 22 s'encastre dans la rainure 21 et y reste prisonnière tout en ménageant un espace pour l'introduction d'une plaque de rebord 9 de drain thermique 3 de carte de circuits électroniques 1 contre le bord vertical 24 de la rainure 21 de la paroi froide 2.

L'axe rotatif de commande 23 se place dans la gouttière de la lamelle de ressort 22 entre les ailes 26, 27 qu'il permet d'écarter ou de rabattre grâce à sa section droite ronde pourvue d'un méplat 30. Il est emprisonné dans la gouttière de la lamelle de ressort 22 par des pattes 31 (figure 3) découpées dans la lamelle de ressort 22 et recourbées autour de lui au niveau d'une ou plusieurs gorges 32 (figure 3) échelonnées sur sa longueur. Son diamètre en dehors et en présence du méplat 30 est respectivement supérieur et inférieur à l'écartement naturel des ailes 26, 27 de la lamelle de ressort 22 de manière à pouvoir les écarter ou les rabattre en fonction de sa position angulaire.

La suppression du corps de connecteur ramène le nombre de pièces du connecteur de trois à deux, ce qui diminue son coût. Elle permet aussi, comme on peut le voir en comparant les figures 1 et 2, de diminuer l'encombrement en épaisseur du connecteur (la lamelle de ressort vient directement au contact du fond de la rainure) qui peut alors être logé dans une rainure moins profonde de la paroi froide. Cette dernière étant creusée de rainures moins profondes peut alors être moins épaisse et donc moins lourde, ce qui est un avantage non négligeable, par exemple pour du matériel aéroporté.

La figure 3 montre, en perspective partielle et démontées l'une des extrémités d'une lamelle de ressort 22 et d'un axe rotatif de commande 23.

On y distingue la forme en gouttière de la lamelle de ressort 22, avec sa section droite en forme générale de U, et différentes pattes découpées :
- des pattes latérales d'écartement 29 qui sont réparties sur sa longueur et prolongent son embase d'un côté pour ménager un espace pour l'introduction d'une plaque de rebord de drain thermique dans la rainure 21 de la paroi froide 2,
- des pattes 31 de maintien de l'axe rotatif de commande qui sont recourbées dans des gorges creusées dans cet axe et
- des pattes latérales de butée 35, 36 placées en extrémité, qui servent à bloquer en translation la lamelle de ressort 22 dans sa rainure 21 pour éviter son déplacement lors d'une introduction d'un rebord 9 de drain thermique par coulissement le long de la rainure.

On y distingue également l'extrémité de manoeuvre de l'axe rotatif de commande 23 avec ses deux méplats 33, 34 définissant des pans pour une clef creuse et avec une gorge 32 destinée au logement d'une patte recourbée 31 de la lamelle de ressort 22 emprisonnant l'axe rotatif de commande dans la lamelle de ressort 22 de manière à autoriser les mouvements de rotation de l'axe et à interdire les mouvements de translation.

Les figures 4 et 5 montrent une vue d'une carte de circuits électroniques 1 fixée entre deux parois froides 2 au moyen de deux connecteurs thermiques selon la figure 2.

La carte de circuits électroniques 1 de forme rectangulaire, comporte une plaque de drain thermique sur toute sa surface, avec des rebords dépassant sur deux côtés opposés. Elle se monte à la manière d'un plateau, par coulissement des rebords opposés de sa plaque de drain thermique le long de deux rainures en vis à vis de deux parois froides disposées côte à côte à une distance convenable. Les deux rainures entre lesquelles se monte la carte renferment chacune un connecteur 20. Les rainures des parois froides ont des profils symétriques par rapport à un plan médian équidistant des parois froides de manière à présenter leur bord vertical d'un même côté de la carte de circuits électroniques. Les connecteurs sont également de formes symétriques par rapport à ce plan médian de manière à présenter d'un même côté les extrémités de leurs axes rotatifs de commande, côté qui est celui visible sur les figures 4 et 5.

La figure 4 montre la position verrouillée. Les axes rotatifs de commande 23 des connecteurs ont leurs méplats 30 tournés vers la base des lamelles de ressort 22 de sorte qu'ils présentent leur grand diamètre entre les ailes des lamelles de ressort 22 et les écartent pour presser les plaques de rebord 9 du drain thermique 3 contre le bord vertical 24 des rainures 21 et assurer un bon contact thermique entre le drain 3 et les parois froides 2.

La figure 5 montre la position déverrouillée. Les axes rotatifs de commande 23 des connecteurs ont leurs méplats 30 tournés vers l'aile des lamelles de ressort 22 venant en vis à vis des plaques de rebord 9 du drain thermique 3 de sorte qu'ils présentent leur petit diamètre entre les ailes 26, 27 des lamelles de ressort 22 et les laissent rabattues ce qui libère les plaques de rebord 9 du drain thermique 3 de toute pression et permet de retirer la carte de circuits électronique 1 par simple coulissement.

On distingue également, sur les figures 4 et 5 qui montrent les parois froides de profil, les pattes latérales de butée 35, 36 dépassant, en dehors des embouchures des rainures 21, de chaque côté de l'extrémité apparente des lamelles de ressort 22, sous les extrémités de manoeuvre des axes rotatifs de commande des connecteurs thermiques. Ces pattes latérales de butée 35, 36 s'encastrent dans des encoches 37 (figure 7) creusés sur le profil de chaque paroi froide à l'embouchure et au niveau du fond des rainures 21. Elles assurent le maintien de l'extrémité de la lamelle de ressort 22 au fond de son logement.

L'autre extrémité de la lamelle de ressort 22 est fixée au fond d'une rainure 21 de la paroi froide grâce à une patte non visible sur les figures qui la prolonge et qui forme une oreille dans laquelle est introduite une vis se vissant dans un taraudage pratiqué au fond de chaque rainure 21. Cette fixation par vis assure le blocage en translation d'un connecteur dans sa rainure. En variante, cette fixation du connecteur dans sa rainure peut être assurée d'une autre façon, par exemple par collage de la lamelle de ressort dans la rainure ou encore par encliquetage d'une patte latérale de la lamelle de ressort dans une encoche portée par la paroi de la rainure comme décrit plus loin en regard des figures 11 et 12.

On voit aussi sur ces figures 4 et 5, sur les profils des parois froides, à la base des rainures 21, des bossages 43 destinés à limiter les possibilités de rotation d'une clef adaptée à l'extrémité de manoeuvre de l'axe rotatif de commande d'un connecteur.

La figure 6 montre l'extrémité d'une telle clef 40. Cette extrémité est creuse et présente une empreinte en creux 41 avec deux méplats de forme complémentaire à celle de l'extrémité de manoeuvre d'un axe rotatif de commande d'un connecteur sur laquelle elle vient s'emboîter. Elle présente en outre un doigt 42 en forme d'un secteur demi-circulaire perpendiculaire aux méplats. Ce doigt 42, obtenu par un usinage à demi-axe, coopère avec un bossage 43 de la paroi froide pour limiter les possibilités de rotation de la clef à un quart de tour.

La figure 7 détaille l'embouchure d'une rainure 21 de logement d'un connecteur dans une paroi froide, du côté de l'extrémité de manoeuvre de l'axe rotatif de commande du connecteur. Elle montre les logements 37 pour les pattes latérales de butées 35, 36 et surtout le bossage 43 limitant la plage de débattement du doigt 42 de la clef à un quart de tour. Ce bossage 43 à contour de forme générale quadrangulaire est disposé en relief sur le profil d'une paroi froide, à la partie inférieure de l'embouchure d'une rainure 21, du côté du bord penché 25. En partie écorné par l'embouchure de la rainure 21, il est sur le trajet du doigt 42 d'une clef 40 engagée sur l'extrémité de manoeuvre de l'axe rotatif de commande du connecteur logé dans la rainure 21. Il présente deux pans latéraux perpendiculaires, un pan latéral 44 parallèle au bord droit 24 de la rainure 21 et un pan latéral 45 parallèle au fond de la rainure 21 sur lesquels bute le doigt 42 de la clef 40 lorsqu'elle parvient en position de verrouillage ou de déverrouillage comme cela apparaît dans les figures 8 et 9.

Les figures 8 et 9 montrent une coupe de section droite d'un connecteur thermique au niveau de l'extrémité de manoeuvre de l'axe rotatif de commande avec une clef engagée, selon les deux positions verrouillée et déverrouillée.

Dans la figure 8, qui est relative à la position verrouillée, le méplat 30 de l'axe rotatif de commande 23 du connecteur est tourné vers la base de la lamelle de ressort 22 de sorte que l'axe rotatif de commande 23 présente son grand diamètre entre les ailes 26, 27 de la lamelle de ressort 22 et les écarte provoquant l'appui de l'aile 26 de la lamelle de ressort 22 sur la plaque de rebord 9 du drain thermique de la carte 1. Les deux méplats 33, 34 de l'extrémité de manoeuvre de l'axe rotatif de commande 23 sont parallèles au fond de la rainure 21 tandis que le doigt 42 de la clef constitué du secteur demi-circulaire vient en butée sur le pan 44 du bossage 43.

Dans la figure 9, qui est relative à la position déverrouillée, le méplat 30 de l'axe rotatif de commande 23 du connecteur est tourné vers l'aile 26 de la lame de ressort 22 de sorte que l'axe rotatif de commande 23 présente son petit diamètre entre les ailes 26, 27 de la lamelle de ressort 22 et laisse au repos l'aile 26 de la lame de ressort 22 qui libère la plaque de rebord 9 du drain thermique de la carte 1. Les deux méplats 33, 34 de l'extrémité de manoeuvre de l'axe rotatif de commande 23 sont parallèles au bord 24 de la rainure 21 tandis que le doigt 42 de la clef constitué du secteur demi-circulaire vient en butée sur le pan 45 du bossage 43.

La figure 10 montre une coupe de section droite d'une variante de réalisation du connecteur thermique avec un profil particulier de la rainure 50 de la paroi froide 2 permettant un maintien de la lamelle de ressort 51 en légère contrainte. L'aile 52 de la lamelle de ressort 51 qui prend appui sur le bord penché 53 de la rainure 50, est repliée à 97° vers sa base tandis que le bord penché 53 de la rainure 50 est en surplomb à 10° au-delà de la perpendiculaire de sorte que l'aile 52 de la lamelle de ressort 51 fait au repos avec sa base un angle légèrement plus ouvert ( 3° de plus) que celui que fait le bord penché 53 en surplomb avec le fond 54 de la rainure 50. Il en résulte que la lamelle de ressort 51 est légèrement contrainte une fois en place dans la rainure 50 de la paroi froide 2. Son maintien dans la rainure 50 est assuré par le fait que son aile 52 qui prend appui sur le bord penché 53 de la rainure, est plus courte que la profondeur de la rainure 50 et vient s'arc-bouter sur un épaulement longitudinal 55 délimité par un liséré latéral en relief sur le bord penché 53 tout au long de l'embouchure de la rainure 50.

Le profil de la rainure 50 de la paroi froide 2 présente un autre épaulement longitudinal 56 délimitant au fond de la rainure 50 une marche 57 longeant le bord perpendiculaire 58 de la rainure 50 opposé au bord penché 53. L'extrémité de la plaque de rebord 9 d'un drain thermique 3 vient buter sur le dessus de cette marche 57 lorsqu'elle est insérée dans la rainure 50 contre le bord perpendiculaire 58 tandis que les pattes latérales d'écartement 59 de la lamelle de ressort 51 prennent appui contre le flanc de cette marche au lieu de passer sous l'extrémité de la plaque de rebord 9 du drain thermique 3 et de parvenir jusqu'au bord perpendiculaire 56 comme dans le mode de réalisation précédent (figure 2). La lamelle de ressort 51 se trouve ainsi encastrée dans la rainure 50 d'une paroi froide 2 entre deux épaulements 55, 56 qui la maintiennent en place et ne permettent qu'un mouvement de translation le long de la rainure. Il n'est alors plus nécessaire de prévoir des pattes latérales de butée (35, 36 figure 3) et leurs encoches (37 figure 7), ce qui simplifie l'usinage de la paroi froide et le montage du connecteur thermique. Cette disposition rend les dimensions de la lamelle de ressort indépendantes de l'épaisseur du rebord du drain thermique et permet de n'avoir qu'un modèle de lamelle de ressort pour diverses épaisseurs de rebord de drain thermique.

Le blocage en translation est assuré, comme le montrent les figures 11 et 12, par une languette latérale 60 qui est découpée dans une aile de la lamelle de ressort 51, celle 52 qui vient au contact du bord penché 54 de la rainure 50 et qui s'encliquette dans une gorge 61 creusée dans la paroi froide 2 perpendiculairement à la rainure 50, à proximité d'une extrémité de cette dernière. Il n'est alors plus nécessaire d'assurer une fixation par vis ou par colle de la lamelle de ressort au fond de la rainure qui lui sert de logement.

## Revendications

1. Connecteur thermique pour fixer une carte (1) ou boîtier d'électronique équipé d'un drain thermique (3) se prolongeant à l'extérieur de la carte ou du boîtier par un rebord (9) en forme de plaque, à une paroi froide (2) en pinçant ledit rebord extérieur (9) en forme de plaque du drain thermique (3) contre un bord (24) d'une rainure (21) pratiquée dans la paroi froide (2), caractérisé en ce qu'il comporte une lamelle de ressort (22) de forme allongée en gouttière, avec deux ailes (26, 27) réunies par une embase (28) et une section droite ayant la forme générale d'un U pourvue, d'un côté de la base du U en regard du rebord extérieur (9) en forme de plaque du drain thermique (3), de pattes latérales d'écartement (29) et un axe rotatif de commande (23) à section droite ronde avec un méplat (30), qui est disposé dans la gouttière de la lamelle de ressort (22) et qui, en prenant appui entre les deux ailes (26, 27) de la lamelle de ressort (22), permet d'en modifier l'écartement en fonction de son orientation, et en ce qu'il est prévu pour être monté dans une rainure (21) de la paroi froide (2) à section en demi-queue d'aronde, avec deux bords (24, 25) tendant à se resserrer en direction de son ouverture pour emprisonner la lamelle de ressort (22).

2. Connecteur selon la revendication 1, caractérisé en ce que la rainure (21) de la paroi froide (2) qui lui sert de logement présente un bord (24) droit, perpendiculaire à la surface de la paroi froide (2) contre lequel vient s'appuyer le rebord extérieur (9) en forme de plaque du drain thermique (3) et un bord penché (25), en surplomb, contre lequel vient s'appuyer une aile (27) de la lamelle du ressort (22).

3. Connecteur selon la revendication 2, caractérisé en ce que l'aile (27) de la lamelle de ressort (22) qui vient s'appuyer contre le bord (25) penché, en surplomb, de la rainure (21) est inclinée vers l'autre aile (26) pour s'adapter à l'inclinaison dudit bord penché (25).

4. Connecteur selon la revendication 2, caractérisé en ce que l'aile (52) de la lamelle de ressort (51) qui vient s'appuyer contre le bord penché (53), en surplomb, de la rainure (50) est plus courte que la profondeur de la rainure (50) et vient s'arc-bouter sur un épaulement longitudinal (55) délimité par un liséré latéral en relief sur le bord penché (53) tout au long de l'embouchure de la rainure (50).

5. Connecteur selon la revendication 1, caractérisé en ce que les pattes latérales d'écartement (28) suivent le fond de la rainure (21), passent sous le rebord extérieur (9) en forme de plaque du drain thermique (3) et viennent s'appuyer contre le bord (24) de la rainure (21) contre lequel est pincé le rebord extérieur (9) en forme de plaque du drain thermique (3).

6. Connecteur selon la revendication 1, caractérisé en ce que le fond de la rainure (50) servant de logement à la lamelle de ressort (51) présente un épaulement longitudinal (56) délimitant une marche (57) qui longe le bord (58) contre lequel est pincé le rebord extérieur (9) en forme de plaque du drain thermique (3) et sur laquelle vient buter ledit rebord extérieur (9), et en ce que les pattes latérales d'écartement (59) de la lamelle de ressort (51) prennent appui contre le flanc de ladite marche (57).

7. Connecteur selon la revendication 1, caractérisé en ce qu'il comporte des moyens pour emprisonner l'axe rotatif de commande (23) dans la gouttière de la lamelle de ressort (21) constitués d'une ou plusieurs pattes de maintien (31) découpées dans la lamelle de ressort (22) et recourbées autour de l'axe rotatif de commande (23).

8. Connecteur selon la revendication 7, caractérisé en ce que la ou lesdites pattes de maintien (31) sont recourbées autour de l'axe rotatif de commande (23) au niveau d'une ou plusieurs gorges (32) échelonnées sur la longueur de l'axe rotatif de commande (23).

9. Connecteur selon la revendication 1, caractérisé en ce qu'il comporte des moyens de blocage en translation (35, 36, 60) de la lamelle de ressort (22, 51) dans la rainure (21, 50) qui lui sert de logement.

10. Connecteur selon la revendication 9, caractérisé en ce que lesdits moyens de blocage comportent des pattes latérales de butée (35, 36) dépassant d'une extrémité de la lamelle de ressort (22) et s'encastrant dans des encoches (37) creusées dans la paroi froide (2) à la base de l'embouchure d'une rainure (21).

11. Connecteur selon la revendication 9, caractérisé en ce que lesdits moyens de blocage comportent une patte prolongeant l'une des extrémité de la lamelle de ressort (22) fixée par une vis au fond d'une rainure (21).

12. Connecteur selon la revendication 9, caractérisé en ce que lesdits moyens de blocage comportent une languette latérale (60) qui est découpée dans une aile de la lamelle de ressort (51) et qui s'encliquette dans un logement (61) creusé dans l'un des bords de la rainure (50).

13. Connecteur selon la revendication 1, caractérisé en ce que l'axe rotatif de commande (23) présente une extrémité de manoeuvre qui dépasse de la lamelle de ressort (22) et qui est pourvue d'une empreinte (33, 34) permettant de la manoeuvrer avec une clef (40).

14. Connecteur selon la revendication 13, caractérisé en ce que ladite clef (40) est pourvue à son extrémité d'une empreinte de forme complémentaire à celle de l'extrémité de manoeuvre de l'axe rotatif de commande (23) et d'un doigt (42) coopérant avec un bossage (43) en relief sur le profil de la paroi froide (2) au débouché d'une rainure (21) pour limiter son débattement en rotation.

15. Connecteur selon la revendication 14, caractérisé en ce que ledit doigt (42) porté par l'extrémité de la clef (40) a la forme d'un secteur demi-circulaire.

16. Connecteur selon la revendication 14, caractérisé en ce que ledit bossage (43) présente latéralement deux pans (45, 46) orientés à angle droit sur lesquels vient buter en bout de course le doigt (42) d'extrémité de la clef (40).

## Patentansprüche

1. Thermischer Verbinder für die Befestigung einer Elektronikkarte (1) oder eines Elektronikgehäuses mit einer Wärmesenke (3), die über die Karte oder das Gehäuse mit einem plattenförmigen Rand (9) vorsteht, an einer kalte Wand (2), indem der äußere plattenförmige Rand (9) der Wärmesenke (3) gegen einen Rand (24) einer Nut (21) in der kalten Wand (2) gepreßt wird, dadurch gekennzeichnet, daß er eine Federlamelle (22) in Form einer länglichen Rinne mit zwei über eine Basis (28) miteinander verbundenen Flanken (26, 27) und einem allgemein U-förmigen Querschnitt aufweist, wobei an der einen Seite der Basis des U gegenüber dem äußeren plattenförmigen Rand (9) der Wärmesenke (3) seitliche Abstandslaschen (29) vorgesehen sind und eine drehbare Steuerwelle (23) mit rundem Querschnitt und einer Abflachung (30) in der Rinne der Federlamelle (22) angeordnet ist, die sich gegen die beiden Flanken (26, 27) der Federlamelle (22) anlegt und eine Veränderung der Abspreizung abhängig von der Orientierung der Steuerwelle erlaubt, und daß der Verbinder in einer Nut (21) der kalten Wand (2) montiert wird, wobei der Querschnitt der Nut zur Hälfte schwalbenschwanzförmig ist, sodaß sich ihre beiden Ränder (24, 25) in Richtung der Nutöffnung einander annähern, um die Federlamelle (22) festzuhalten.

2. Verbinder nach Anspruch 1, dadurch gekennzeichnet, daß die Nut (21) der kalten Wand (2) zur Aufnahme des Verbinders einen geraden Rand (24) senkrecht zur Oberfläche der kalten Wand (2), gegen den der äußere plattenförmige Rand (9) der Wärmesenke (3) anliegt, und einen schrägen, überkragenden Rand (25) besitzt, an dem eine Flanke (27) der Federlamelle (22) anliegt.

3. Verbinder nach Anspruch 2, dadurch gekennzeichnet, daß die Flanke (27) der Federlamelle (22), die am schrägen, überkragenden Rand (25) der Nut (21) anliegt, zur anderen Flanke (26) hin geneigt ist und sich an die Neigung des schrägen Rands (25) anpaßt.

4. Verbinder nach Anspruch 2, dadurch gekennzeichnet, daß die Flanke (52) der Federlamelle (51), die am schrägen, überkragenden Rand (53) der Nut (50) anliegt, kürzer als die Tiefe der Nut (50) ist und sich über eine Längsschulter (55) wölbt, die durch eine seitliche vorspringende Kante am schrägen Rand (53) über die ganze Länge der Nut (50) definiert ist.

5. Verbinder nach Anspruch 1, dadurch gekennzeichnet, daß seitliche Abstandslaschen (29) entlang des Grundes der Nut (21) verlaufen, unter dem äußeren plattenförmigen Rand (9) der Wärmesenke (3) verlaufen und sich am Rand (24) der Nut (21) abstützen, gegen den der äußere plattenförmige Rand (9) der Wärmesenke (3) gepreßt wird.

6. Verbinder nach Anspruch 1, dadurch gekennzeichnet, daß der Grund der Nut (50) zur Aufnahme der Federlamelle (51) eine Längsschulter (56) aufweist, die eine Stufe (57) entlang des Rands (58) definiert, gegen den der äußere plattenförmige Rand (9) der Wärmesenke (3) gepreßt wird und an dem dieser äußere Rand (9) anliegt, und daß die seitlichen Abstandslaschen (59) der Federlamelle (51) sich an der Flanke der Stufe (57) abstützen.

7. Verbinder nach Anspruch 1, dadurch gekennzeichnet, daß er Mittel aufweist, um die drehbare Steuerwelle (23) in der Rinne der Federlamelle (22) zu halten, und daß diese Mittel aus einer oder mehreren Haltelaschen (31) bestehen, die aus der Federlamelle (22) ausgeschnitten sind und um die drehbare Steuerwelle (23) herumgebogen sind.

8. Verbinder nach Anspruch 7, dadurch gekennzeichnet, daß die Haltelasche oder Haltelaschen (31) um die drehbare Steuerwelle (23) in Höhe einer oder mehrerer Kehlen (32)) herumgebogen sind, die über die Länge der drehbaren Steuerwelle (23) verteilt sind.

9. Verbinder nach Anspruch 1, dadurch gekennzeichnet, daß er Mittel (35, 36, 60) zur Blockierung der Federlamelle (22, 51) in der dem Verbinder als Sitz dienenden Nut (21, 50) aufweist.

10. Verbinder nach Anspruch 9, dadurch gekennzeichnet, daß die Blockiermittel seitliche Anschlaglaschen (35, 36) aufweisen, die an einem Ende der Federlamelle (22) vorstehen und in Nischen (37) eindringen, die in die kalte Wand (2) an der Basis der Mündung einer Nut (21) eingeschnitten sind.

11. Verbinder nach Anspruch 9, dadurch gekennzeichnet, daß die Blockiermittel eine Lasche aufweisen, die ein Ende der Federlamelle (22) verlängert und mit einer Schraube am Boden der Nut (21) befestigt ist.

12. Verbinder nach Anspruch 9, dadurch gekennzeichnet, daß die Blockiermittel eine seitliche Zunge (60) aufweisen, die aus einer Flanke der Federlamelle (51) ausgeschnitten ist und in einem Sitz (61) einrastet, der in einem der Ränder der Nut (50) ausgebildet ist.

13. Verbinder nach Anspruch 1, dadurch gekennzeichnet, daß die drehbare Steuerwelle (23) ein Betätigungsende aufweist, das über die Federlamelle (22) vorsteht und eine Prägung (33, 34) zur Betätigung mit einem Schlüssel (40) aufweist.

14. Verbinder nach Anspruch 13, dadurch gekennzeichnet, daß der Schlüssel (40) an seinem Ende eine Prägung, die zu der am Betätigungsende der drehbaren Steuerwelle (23) komplementär ist, sowie einen Finger (42) besitzt, der mit einem über das Profil der kalten Wand (2) am Ende einer Nut (21) vorstehenden Vorsprung (43) zur Begrenzung der Drehbewegung des Schlüssels zusammenwirkt.

15. Verbinder nach Anspruch 14, dadurch gekennzeichnet, daß der Finger (42) am Ende des Schlüssels (40) die Form eines Halbkreissektors besitzt.

16. Verbinder nach Anspruch 14, dadurch gekennzeichnet, daß der Vorsprung (43) seitlich zwei Anschlagflächen (45, 46) im rechten Winkel zueinander aufweist, an denen am Ende der Drehbewegung der Finger (42) am Ende des Schlüssels (40) anschlägt.

## Claims

1. Thermal connector for fastening an electronics card (1) or housing equipped with a heat sink (3) which is extended to the outside of the card or of the housing by a plate-shaped rim (9), having a cold wall (2) pinching the said external plate-shaped rim (9) of the heat sink (3) against an edge (24) of a groove (21) made in the cold wall (2), characterized in that it includes a spring leaf (22) of elongate trough shape, with two legs (26, 27) joined together by a base (28) and a cross section having the general shape of a U provided, on one side of the base of the U opposite the external plate-shaped rim (9) of the heat sink (3), with lateral spacing tabs (29) and a rotary drive spindle (23) of round cross section with a flat (30), which is placed in the trough of the spring leaf (22) and which, by bearing between the two legs (26, 27) of the spring leaf (22), makes it possible to modify the spacing thereof according to its orientation, and in that it is designed to be fitted into a groove (21) in the cold wall (2) having a half-dovetail cross section with two edges (24, 25) tending to close up in the direction of its opening in order to trap the spring leaf (22).

2. Connector according to Claim 1, characterized in that the groove (21) in the cold wall (2), which serves to house it, has a straight edge (24) perpendicular to the surface of the cold wall (2), against which edge the external plate-shaped rim (9) of the heat sink (3) bears and an overhanging inclined edge (25) against which one leg (27) of the spring leaf (22) bears.

3. Connector according to Claim 2, characterized in that the leg (27) of the spring leaf (22) which bears against the overhanging inclined edge (25) of the groove (21) is angled towards the other leg (26) in order to match the inclination of the said inclined edge (25).

4. Connector according to Claim 2, characterized in that the leg (52) of the spring leaf (51) which bears against the overhanging inclined edge (53) of the groove (50) is shorter than the depth of the groove (50) and butts against a longitudinal shoulder (55) bounded by a lateral border in relief on the inclined edge (53) all along the mouth of the groove (50).

5. Connector according to Claim 1, characterized in that the lateral spacing tabs (28) follow the bottom of the groove (21), pass under the external plate-shaped rim (9) of the heat sink (3) and bear against the edge (24) of the groove (21), against which edge the external plate-shaped rim (9) of the heat sink (3) is pinched.

6. Connector according to Claim 1, characterized in that the bottom of the groove (50) which serves to house the spring leaf (51) has a longitudinal shoulder (56) defining a step (57) which lies along the edge (58) against which the external plate-shaped rim (9) of the heat sink (3) is pinched and against which the said external rim (9) butts, and in that the lateral spacing tabs (59) of the spring leaf (51) bear against the flank of the said step (57).

7. Connector according to Claim 1, characterized in that it includes means for trapping the rotary drive spindle (23) in the trough of the spring leaf (22), these means consisting of one or more retaining tabs (31) cut in the spring leaf (22) and bent over about the rotary drive spindle (23).

8. Connector according to Claim 7, characterized in that the retaining tab or tabs (31) are bent over about the rotary drive spindle (23) at one or more recesses (32) staggered along the length of the rotary drive spindle (23).

9. Connector according to Claim 1, characterized in that it includes means (35, 36, 60) for translationally immobilizing the spring leaf (22, 51) in the groove (21, 50) which serves to house it.

10. Connector according to Claim 9, characterized in that the said immobilizing means include lateral stop tabs (35, 36) which extend beyond one end of the spring leaf (22) and which fit into notches (37) cut out of the cold wall (2) at the base of the mouth of a groove (21).

11. Connector according to Claim 9, characterized in that the said immobilizing means include a tab which extends one of the ends of the spring leaf (22) fastened by a screw to the bottom of a groove (21).

12. Connector according to Claim 9, characterized in that the said immobilizing means include a lateral tongue (60) which is cut in one leg of the spring leaf (51) and which snaps into a housing (61) cut out of one of the edges of the groove (50).

13. Connector according to Claim 1, characterized in that the rotary drive spindle (23) has a manoeuvring end which extends beyond the spring leaf (22) and which is provided with an indent (33, 34) allowing it to be manoeuvred using a key (40).

14. Connector according to Claim 13, characterized in that the said key (40) is provided at its end with an indent having a shape complementary to that of the manoeuvring end of the rotary drive spindle (23) and with a finger (42) which engages with a projection (43) in relief on the profile of the cold wall (2) at the opening of a groove (21) in order to limit its rotational movement.

15. Connector according to Claim 14, characterized in that the said finger (42) carried by the end of the key (40) has the shape of a semicircular sector.

16. Connector according to Claim 14, characterized in that the said projection (43) has, laterally, two faces (45, 46) oriented at right angles, against which the end finger (42) of the key (40) butts at the end of travel.
